# EUROPEAN PATENT SPECIFICATION

(11) **EP 2 808 912 B1**
(45) Date of publication and mention of the grant of the patent: **30.06.2021**
(21) Application number: 13169321.0
(22) Date of filing: 27.05.2013
(51) Int. Cl.: H01L 33/60, H01L 33/62, H01L 33/48, H01L 33/00, H05K 3/30

(54) **Method for assembling a circuit carrier with a housing component, and an optical unit**
Verfahren zum Zusammenbau eines Schaltungsträgers mit einer Gehäusekomponente, und eine optische Einheit
Procédé d'assemblage d'un support de circuit avec un composant de boîtier et une unité optique

(43) Date of publication of application: 03.12.2014
(73) Proprietor: Rockwell Automation Switzerland GmbH, 5000 Aarau (CH)
(72) Inventor: Schulze, Henry, 7302 Landquart (CH); Hardegger, Martin, 7320 Sargans (CH)
(74) Representative: Grünecker Patent- und Rechtsanwälte PartG mbB

(56) References cited:
- EP-A1- 2 306 068
- EP-A1- 2 660 629
- EP-A1- 2 660 644
- EP-A2- 2 159 853
- WO-A1-2012/127355
- US-A- 4 404 741
- US-A- 4 651 203
- US-A1- 2002 001 984
- US-A1- 2009 147 498
- US-A1- 2010 067 240

## Description

The present invention relates to a method for assembling a circuit carrier with a housing component and furthermore to an optical unit for emitting and/or receiving radiation that is fabricated using this particular method of assembling and aligning the circuit carrier with the housing component.

When assembling electronic components, they are usually mounted on some sort of circuit carrier and the circuit carrier has to be mounted at or within a mechanical part that forms a housing or is a part thereof. In a plurality of application fields, for instance when assembling optoelectronic components, such as light emitting diodes (LED) or light receiving components, such as photo diodes, a particularly accurate positioning of the electronic component with respect to the housing or another mechanical or optical part, e. g. lenses and apertures, or an opening of the housing, has to be achieved. Usually, this alignment is either done by means of some mechanical fitting or by providing a fiducial on a printed circuit board (PCB) which is optically evaluated by means of an automatic assembly device. The alignment of the PCB is achieved by means of mechanical positioning aids, e. g. openings. Hence, the tolerances of two alignment steps have to be taken into account. The fiducial is for instance formed by a structure, like a cross, a circle, or the like, provided in the metallization layer of the circuit carrier.

Documents EP 2 660 629 A1 and EP 2 600 644 A1 are considered as comprised in the state of the art according to Art. 54(3) EPC. Both documents disclose a mounting process where the alignment of a printed circuit board (carrying the electronic component) with respect to an opening is performed by means of a plurality of mounting projections that interact with corresponding openings in the PCB for mounting same at the module body.

US 2009/147498 A1 relates to a light emitting device that comprises a board with a plurality of lead frames, and a light emitting diode chip electrically connected to the lead frames, and a reflective member formed coupled on the board while surrounding the light emitting diode. The alignment between the board and the reflective member is defined by the interaction of fixing pins with corresponding fixing holes.

EP 2 159 853 A2 discloses a light source device that includes a circuit board, a solid state lighting element, and a hollow generally cylindrical metal reflector. The circuit board has a circuit layer formed thereon. The solid state lighting element is mounted on the circuit board and electrically connected to the circuit layer. The reflector is mounted on the circuit board and insulated from the circuit layer. An inner surface of the reflector surrounds the solid state lighting element and is capable of reflecting and directing light from the solid state lighting element towards a side of the reflector far from the circuit board.

US 2010/067240 A1 discloses an optical cup for a lighting module. The lighting module comprises a base panel and a plurality of LED chips attached directly to the base panel. The LED chips are in electrical communication with conductive traces on the base panel, which deliver current to the LED chips. The optical cups are arranged around each of the plurality of LED chips that form a lighting module arrangement.

Furthermore, prior art US 4 404 741 A discloses a device for the alignment of a part and the substrate designed to receive it. The device contains a plate, on the horizontal flat upper surface of which an XY table can slide, a blocking device for temporarily interrupting any translation of the XY table, but leaving it free to rotate on a given vertical axis, a gripping device and an optical viewing device. The blocking device preferably consists of an electromagnet mounted for rotation in a bore of the plate.

US 4 651 203 A discloses a video controlled article positioning system. According to this document, a video signal of the article from a television camera is used to accurately position the article. Vertical and horizontal sync signals from the camera i.e. to generate first and second boundary markers to provide ±X and ±Y positioning, respectively. Sensitivity markers are also generated to monitoring systems sensitivity in non-object areas. The magnitude of the coincidence between the article and the boundary markers is utilized to control the motion of the positioning adjustment.

US 2002/001984 A1 discloses a method for producing an electrical connection between a flexible printed circuit board and a metallic mating contact member. A light-radiating opening is formed in a first insulating layer and a connecting opening is formed in a second insulating layer. A section of the metallic mating contact member is brought into bearing contact with a conductor track through the connecting opening. Welding/soldering of the conductor track to the connecting section is brought about by radiant heating by means of laser light directed through the light-radiating opening.

EP 2 306 068 A1 relates to a light illuminating device. To reliably keep an LED board and a heat conductive member in close contact to improve the heat-dissipation efficiency and to reliably position an LED and an optical element, such as a lens part, arranged in a housing are a slim LED board, the housing that has an accommodating concave part to house the LED board, a heat conductive member that is arranged between the LED board and the accommodating concave part, a pressing member that has the lens part and that presses a long side edge part of the LED board against a bottom surface of the accommodating concave part of the housing, a securing mechanism for securing the LED board, the heat conductive member and the pressing member to the housing, and a positioning mechanism for positioning the lens part relative to the LED.

WO 2012/127355 A1 relates to a substrate comprising: a first segment provided with a first contact pad for connection of a first light emitting element; and a second segment provided with a second contact pad for connection of a second light emitting element, wherein the substrate is provided with at least one through-hole that extends from an edge of the substrate to a point within the substrate, such that a relative movement, in a plane of the substrate, can be achieved between the first segment of the substrate and the second segment of the substrate by applying a mechanical force to the substrate. This makes very accurate alignment to a multiple cavity optical system possible without adjusting the optics, thereby enabling a more convenient and time efficient process in production.

However, in particular for optoelectronic applications, there is still a need of providing an improved alignment method that leads to a higher accuracy of the positioning between the housing component and the electronic component and furthermore can be performed in a more cost-effective and simple way.

This object is solved by the subject matter of the independent claims. Advantageous embodiments of the method and the optical unit according to the present invention are the subject matter of the dependent claims.

The present invention is based on the idea that a most accurate alignment between an opening in the housing component and the electronic component assembled on a circuit carrier can be achieved by using the electronic component itself as an indicator for its position. Thus, the electronic component by itself has the functionality of a fiducial and its position is evaluated with respect to an opening in the housing component. This solution has firstly the advantage that no intermediate structures are used which introduce further tolerances and inaccuracies into the alignment process. Further, the production process is simplified because no additional fiducials or mechanical alignment structures have to be provided in addition to the assembled electronic component.

Apart from an opening, also a peripheral region of the housing component or a transparent region can be used for aligning the housing component with the mounted electronic component.

After the alignment step, the circuit carrier and the housing components are connected to each other mechanically for maintaining the aligned position.

A well-established possibility for aligning the circuit carrier is an optical evaluation by means of a camera, wherein the position of the electronic component is monitored by taking images of the electronic component through the first opening or another mechanical reference, and to evaluate these images digitally for reaching an accurate position of the two components with respect to each other. E. g. for optical systems without an aperture, the chip on the circuit carrier has to be aligned with respect to an optical axis of a lens.

The present invention is particularly suitable for aligning parts of the housing with circuit carriers that have optoelectronic components mounted thereon. Such optoelectronic components can be light-emitting diodes (LEDs) or photodiodes for receiving radiation, but also time-of-flight elements used for safety and monitoring applications.

In an embodiment of the claimed invention, the J Z way of fixing the circuit carrier to the housing components is to perform a laser welding step. To this end, the printed circuit board is provided with a second opening that allows the laser beam being directed to the housing component. Z The housing component comprises a respective weldable material at the position of the second opening, same is melted by means of the laser beam and establishes a connection to the circuit carrier.

As an alternative, in examples not forming part of the claimed invention, or additionally, J also a hot stamping procedure can be performed. Furthermore, any other suitable method of fixing the two parts at each other, like gluing or overmolding, can also be used in examples not forming part of the claimed invention.

The accurate alignment between an optoelectronic component mounted on the circuit carrier and an opening provided in a housing component is of particular relevance when the opening is an optically functional aperture which is intended to shape either an incident or an emitted radiation beam during the operation of the optoelectronic component.

For instance, in the application field of light curtains and light barriers, often radiation beams with a small opening angle are required. To this end, apertures with a defined diameter are arranged in front of the light emitting elements for reducing the opening angle.

On the other hand, also for the receiving element an aperture can be advantageous to filter out any noise radiation.

In any case, the aperture has to be located as exactly as possible in regard to an optical axis of the optical component.

The present invention is particularly advantageous for electronic components that are mounted by means of a chip-on-board technique. However, the invention can of course also be used with SMD (surface mounted device) components. Moreover, when directly using the chip position of a light emitting diode (LED) within its SMD housing for the alignment, the inaccuracies of the position of the LED chip within the SMD housing can be eliminated by using the alignment technique according to the present invention. As the tolerance of an LED chip within an SMD housing is larger, the effect of the inventive alignment is even higher than for COB components.

For ensuring that any generated heat is dissipated quickly and, furthermore, that the thermal expansion is kept as low as possible, so-called MCPCBs (metal core printed circuit boards) can be used as the circuit carrier. The metal core usually comprises an aluminium alloy which is covered by an electrically insulating outer layer. The principles of the present invention, however, can of course also be used with any other sort of circuit carrier, such as ceramic circuit carriers or printed circuit boards.

In order to establish a predefined distance between the housing element and the circuit carrier, one or more distancing elements are provided at the circuit carrier. This can for instance be an insert molding which covers a part of the surface of the printed circuit board.

The easiest way of performing the alignment according to the present invention is to use a movable XY actuator connected a video processing unit that takes and processes images of the electronic component through the opening or along a peripheral area of the housing component.

By providing a metal structure within the housing component, a thermal and mechanical stability of the housing component can be achieved that further enhances the accuracy of the alignment between housing element and electronic component. In particular, the housing component can be formed by overmolding metal structure, as this is proposed by European patent applications EP 12166435.3 or EP 12166434.6.

The accompanying drawings are incorporated into and form a part of the specification to illustrate several embodiments of the present invention. These drawings together with the description serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form-individually or in different combinations-solutions according to the present invention, provided that they fall within the scope of the appended claims. Further features and advantages will become apparent from the following more particular description of the various embodiments of the invention, as illustrated in the accompanying drawings, in which like references refer to like elements, and wherein:
- **FIG. 1**: is a schematic representation of a part of a circuit carrier;
- **FIG. 2**: is a schematic representation of a circuit carrier according to a first embodiment;
- **FIG. 3**: shows a first step of an alignment procedure according to the present invention;
- **FIG. 4**: illustrates a next step of the alignment procedure;
- **FIG. 5**: shows a laser welding step for fixing the aligned structure of FIG. 4;
- **FIG. 6**: shows an example of an optical unit according that can advantageously be assembled using the alignment method according to the present disclosure, which forms part of the claimed invention when a laser welding step is used for fixing the aligned structure;
- **FIG. 7**: shows another example of an optical unit according that can advantageously be assembled using the alignment method according to the present disclosure;
- **FIG. 8**: illustrates the alignment of more than one component using the method according to the present disclosure.

The circuit carrier 100 carries an electronic component 102 which is connected to respective interconnection leads provided on the circuit carrier by means of a chip-on-board (COB) technique.

The chip-on-board technique implies that the die itself is directly mounted on a circuit carrier, such as a printed circuit board 100 without providing any further housing around the electronic component 102. This is a very common method of mounting, for instance LED dies. The circuit carrier according to the present invention may for instance be formed by a metal core PCB (MCPCB) which has a core comprising an aluminium alloy. As already mentioned, also other types of circuit carriers may be used for the mounting procedure according to the present invention.

However, as already mentioned above, also standard LED chips in SMD housings can advantageously be assembled using an alignment according to the present invention.

A characteristic feature of the COB technique is that the positioning of the electronic component 102 on the printed circuit board itself is very accurate in respect to other parts of the circuit carrier 100. For instance, the distance d of the electronic component 102 in respect to the center of a bore hole 104 which can for instance be used for engaging with a tool that moves the PCB during the alignment procedure, can be aligned with a tolerance of ± 50 µm or less.

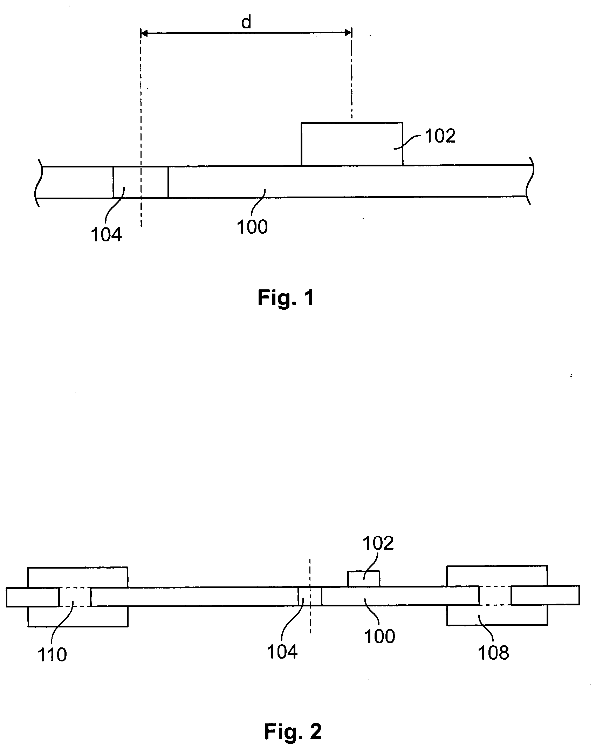

The alignment of a circuit carrier 100 with respect to a part of a housing 106 will be explained in detail with respect to figures 2 to 5.

In the shown embodiment, the circuit carrier 100 has an electronic component 102 and an engaging opening 104, where a robot for moving the circuit carrier 100 can engage. Distancing elements 108 are provided by overmolding a printed circuit board, for instance a metal core printed circuit board, MCPCB. For a subsequent welding process, the PCB 100 has openings 110. For the alignment process, the circuit carrier 100 is brought into vicinity of the housing component 106 and a tool 112, which allows for a precise movement of the circuit carrier 100 in at least X and Y direction, engages with the opening 104 provided at the circuit carrier 100.

The housing component has an aperture 114, which is to be aligned with a position of the electronic component 102. By means of an actuator 112, the position of the circuit carrier 100 is changed with respect to the housing component 104 until the electronic component 102 can be imaged directly within the aperture 114. The distancing elements 108 maintain a predefined distance between the electronic component 102 and the housing component 106.

Instead of the aperture 114, in an example not forming part of the claimed invention, Z also a transparent part such as a lens can be present, and the electronic component, e. g. an LED, is aligned with respect to this part.

An optical alignment system views the electronic component 102 from above and ensures the perfect alignment of the two components in respect to each other. After the alignment has been finished, a next step is the final fixing of the circuit carrier 100 with respect to the housing component 106. According to the present invention, this is done by means of a laser welding step.

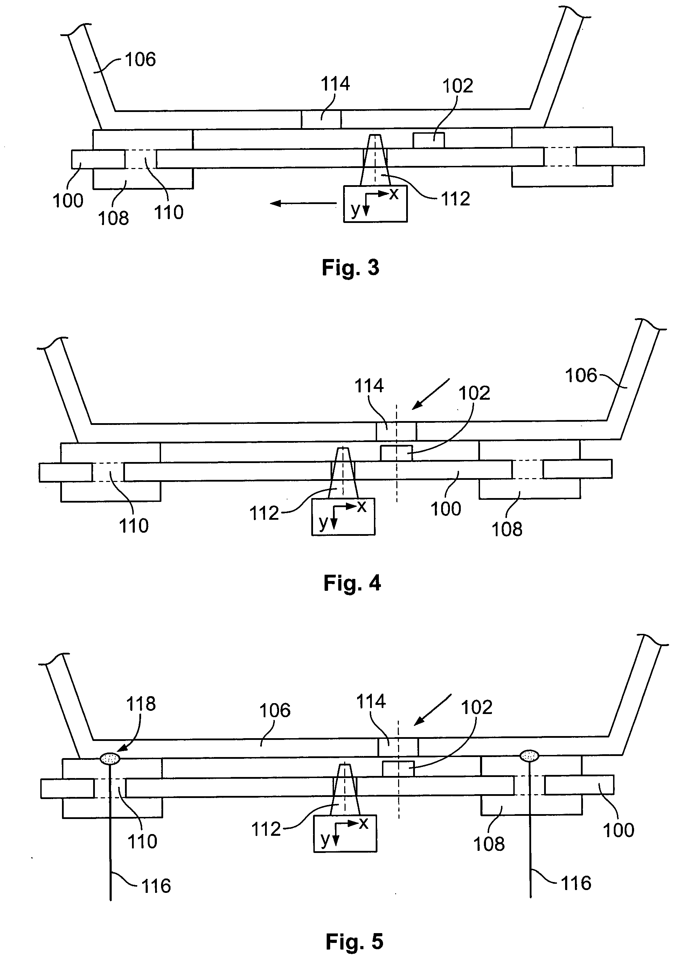

In FIG. 5, reference numeral 116 symbolizes an applied laser beam, which is directed through the openings 110 which are provided for the welding step. The energy of the laser beam 116 leads to a melting of the material of the housing component 106 and of the distancing elements 108, and thus forms a secure laser welded connection 118. Alternatively, in examples not forming part of the claimed invention, also a hot stamping step, or any other suitable process e. g. gluing, ultrasonic welding or the like, can be performed in order to fix a PCB 100 at the housing component 106 while held in position by a measuring and positioning system.

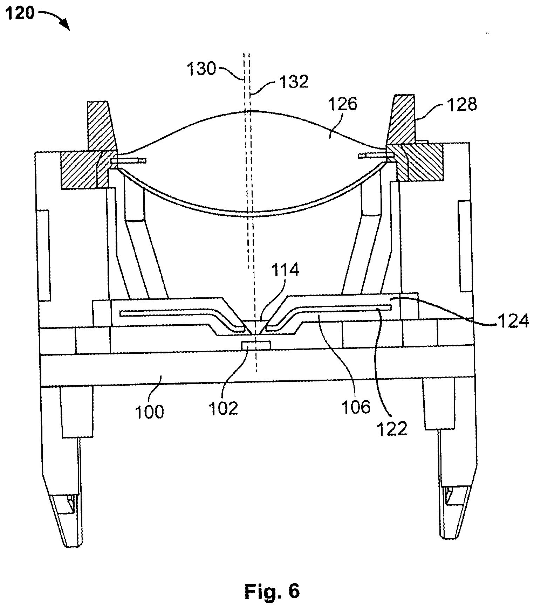

FIG. 6 shows an exemplary application of the present alignment method where an optical unit 120 carries the circuit carrier 100, which has to be aligned in view of a housing component 106 which has an aperture 114 for focusing the light emitted from an LED 102.

The alignment between the LED and the aperture 114 can directly be ensured by imaging the LED chip 102 through the aperture 114. The fixing between a printed circuit board 100 and the housing component 106 may for instance be established by an overmolding step. In an embodiment of the claimed invention a laser welding step is provided.

Alternatively, the alignment can also be performed with respect to the transparent housing part 128 (shown with a hatching in FIG. 6) in order to align the light emitting centre line 132 with respect to the middle axis 130 of the lens 126. For instance, the lens 126 and the transparent part 128 can be fabricated as one integrated molded part, so that the accuracy of the alignment step will only be influenced by the tooling accuracy.

As shown in FIG. 6, the housing part 128 can fabricated as a two-component moulded part in the same moulding tool for the lens and the carrier. Such a technique is for instance described for forming optical curtains in the European patent application No. 12 166 434.6, "Optical Module and Optical Unit for a Light Curtain, and Fabrication Method".

By this integrated two-component technique the tolerance from the lens to the housing component can be minimized and an improved overall positioning accuracy can be achieved. Such an improved positioning accuracy is not only important for larger units such as light curtains, but can also be used advantageously for other sensor applications, such as time of flight (TOF) sensors or optical sensors using a reflective technique. Sensors based in reflective concepts usually have one or more receivers and one or more transmitters integrated therein, and therefore benefit particularly from an improved assembly accuracy between the optical components and parts of the housing, e. g. lenses or apertures.

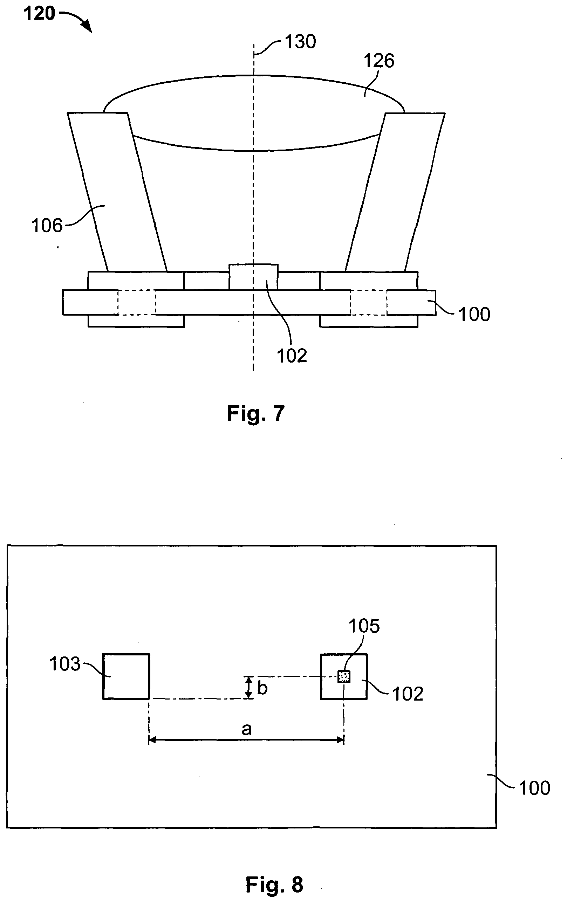

Of course, the present disclosure can also be used for an alignment of an electronic component 102 with respect to a lens 126 without having an aperture at all. Such a system is depicted in FIG. 7. All other features are analogous to what has be explained with respect to the previous figures.

By fabricating the housing component 106 in a way that a metal core 122 is arranged within a plastic outer layer 124, a particularly precise and accurate alignment without the influence of thermal expansion can be maintained after the alignment step.

The advantage of the alignment technique according to the present disclosure can firstly be seen in the fact that only the COB tolerances influence the alignment and that therefore a much better accuracy can be reached than for example with snap hook applications. The bore holes for welding represent the tolerance window for the laser beam, so that the laser beam does not have not to be exact in its welding position.

When aligning a single LED with respect to an aperture or a lens, all tolerances regarding the mounting of the LED on the PCB can be compensated, including the placement tolerance of the LED within a housing. The resulting tolerance is only influenced by how accurate the optical alignment according to the present disclosure is performed, and by a possible displacement of the alignment due to the subsequent laser welding or other fixing process. If more than one electronic component is mounted on the circuit carrier, naturally the tolerance of the positioning of the components in respect to each other has an impact on the alignment quality of those components which are not directly used as fiducial. However, the positioning of different components with respect to each other usually has acceptably low tolerances, and is in particular more accurate than the alignment between a fiducial on the print and the electronic component(s). Hence, the alignment according to the present disclosure also leads to a significant improvement where a plurality of electronic components is involved.

Furthermore, the printed circuit board 100 does not have to be insert molded over big areas, which is difficult for the sealing in the insert molding tool, but only in the small area where the distancing elements 108 are arranged. Hence, no printed circuit board deflection due to thermal influences occurs. The electronic actuator tool 112 can be controlled by a camera and video processing unit that images the position of the electronic component 102 through the aperture 114.

Figure 8 illustrates the situation where a first and a second electronic component 102, 103 are mounted on the printed circuit board 100. The first electronic component for instance comprises a receiver integrated circuit with an optically sensitive area 105, wherein the first electronic component 102 is directly used as a fiducial for its own position on the circuit carrier. According to this embodiment, the first electronic component 102 is not only used as a fiducial when aligning the PCB with respect to a mechanical part such as a housing or a lens, but also during the PCB assembly. In particular, the optically sensitive area 105 may be used as a fiducial for the accurate placement of the second electronic component 103 on the printed circuit board 100. For instance when using a COB technique, this alignment of the second electronic component 103 using the already assembled first electronic component 102 can be implemented in a particularly easy way. Hence, the defined distances a and b between the first and second electronic components 102, 103 can be observed precisely.

In a next step, the alignment and mounting of the assembled PCB can be performed as described above for a chip with an LED as the first electronic component 102. In particular, the optically sensitive area 105 is again used as a fiducial, now for aligning the PCB with respect to a housing component such as a lens or aperture.

By means of this alignment technique-in particular when combining same with a two-component housing as shown in FIG. 6-a completely new performance level can be achieved for the design of reflective sensors and TOF sensors. For such applications, firstly the highly accurate alignment of two electronic components can be used for the assembly of a transmitter and a receiver on the circuit carrier. Next, the concept of a more-component moulded housing (again using one of the transmitter and the receiver as the fiducial) leads to a highly exact alignment of the housing components with respect to the electronic components. This leads to an enhanced radiation yield and sensitivity because the emitted radiation and the sensing areas of the receiver part are correlated to each other much better.

It could be shown that either any structure on a particular electronic component, such as for instance the metal electrodes of an LED, or the edges of a chip (for instance when mounting a TOF component) can be used as a fiducial according to the present disclosure. The invention is as defined in the appended claims.

**Reference Numerals:**

| **Reference Numeral** | **Description** |
|---|---|
| 100 | circuit carrier |
| 102 | first electronic component |
| 103 | second electronic component |
| 104 | engaging opening |
| 105 | optically sensitive area of a receiver |
| 106 | housing component |
| 108 | distancing elements |
| 110 | opening for welding |
| 112 | tool |
| 114 | aperture |
| 116 | laser beam |
| 118 | laser welded connection |
| 120 | optical unit |
| 122 | metal core |
| 124 | plastic outer layer |
| 126 | lens |
| 128 | transparent part |
| 130 | optical axis of the lens |
| 132 | optical axis of the electronic component/LED |

## Claims

1. Method of assembling a circuit carrier (100) with a housing component (106), wherein the method comprises the following steps:
providing said housing component (106) having at least one first opening (114), and providing said circuit carrier (100) having at least one second opening (110), wherein on said circuit carrier (100) there is arranged at least one first electronic component (102); aligning said circuit carrier (100) in a way that said electronic component (102) is aligned with respect to said first opening (114) in the housing component (106), wherein the first electronic component (102) is directly used as a fiducial for its own position on the circuit carrier (100); and
fixing the circuit carrier (100) at the housing component (106) by performing a laser welding step, wherein the laser welding step comprises directing a laser beam through said at least one second opening (110).

2. Method according to claim 1, wherein in the step of aligning the circuit carrier (100), an optical evaluation of the position of the first electronic component (102) is performed by taking and evaluating images of the electronic component (102) through the first opening (114).

3. Method according to claim 1 or 2, wherein said first electronic component (102) is an optoelectronic component which is operable to send and/or receive radiation.

4. Method according to one of the preceding claims, wherein, in the step of fixing the circuit carrier (100) at the housing component (106), a hot stamping step is performed.

5. Method according to one of the claims 1 to 4, wherein said first opening (114) in the housing component (106) is an optically functional aperture for shaping an incident and/or emitted radiation beam during operation of the optoelectronic component.

6. Method according to one of the preceding claims, wherein said first electronic component (102) is assembled on the circuit carrier (100) in a chip-on-board, COB, technique.

7. Method according to one of the preceding claims, wherein said circuit carrier (100) comprises a metal core printed circuit board, MCPCB.

8. Method according to one of the preceding claims, further comprising the step of providing at least one distancing element (108) at the circuit carrier (100) for establishing a predefined distance between the housing component (106) and the circuit carrier (100) in a direction across a plane defined by the circuit carrier.

9. Method according to one of the preceding claims, wherein, during the alignment step, said circuit carrier (100) is moved with respect to the housing component (106) by means of electronically controlled actuators in at least two dimensions.

10. Method according to one of the preceding claims, further comprising the step of aligning a second electronic component (103) when assembling same on said circuit carrier (100) by using the first electronic component (102) as a fiducial for its own position on the circuit carrier (100).

11. Optical unit (120) for emitting and/or receiving radiation, said optical unit (120) comprising:
a housing component (106) having at least one first opening (114), the housing component being operable for shaping said radiation,
a circuit carrier (100) having at least one optoelectronic component (102) which is operable to send and /or receive said radiation, and having at least one second opening (110),
wherein said circuit carrier (100) is aligned in a way that said optoelectronic component (102) is aligned with respect to said first opening (114) in the housing component (106),
**characterized in that** at least one distancing element (108) is provided by overmolding the circuit carrier (100) and the at least one second opening (110) to maintain a predetermined distance between the at least one optoelectronic component (102) and the housing component (106) and to direct a laser beam (116) through the at least one second opening (110); wherein the circuit carrier (100) is fixed to the housing component (106) with a laser welded connection (118) formed by melting the material of the housing component (106) and of the at least one distancing element (108).

12. Optical unit according to claim 11, wherein said circuit carrier (100) comprises a metal core printed circuit board, MCPCB.

13. Optical unit according to claim 12, wherein said metal core comprises an aluminium alloy.

14. Optical unit according to one of the claims 11 to 13, wherein said housing component (106) comprises an overmolded metal structure.

15. Optical unit according to one of the claims 11 to 14, wherein said housing component (106) comprises a two-component part integrating at least one transparent lens (126) with an opaque housing.

## Patentansprüche

1. Verfahren zum Zusammenbauen eines Schaltungsträgers (100) und einer Gehäusekomponente (106), wobei das Verfahren die folgenden Schritte umfasst:
Bereitstellen der Gehäusekomponente (106), die wenigstens eine erste Öffnung (114) aufweist, und Bereitstellen des Schaltungsträgers (100), der wenigstens eine zweite Öffnung (110) aufweist, wobei an dem Schaltungsträger (100) wenigstens ein erstes elektronisches Bauteil (102) angeordnet ist; Ausrichten des Schaltungsträgers (100) in einer Weise, dass das elektronische Bauteil (102) auf die erste Öffnung (114) in der Gehäusekomponente (106) ausgerichtet ist, wobei das erste elektronische Bauteil (102) direkt als ein Bezugspunkt für seine eigene Position auf dem Schaltungsträger (100) dient; und
Befestigen des Schaltungsträgers (100) an der Gehäusekomponente (106) mittels Ausführen eines Laserschweiß-Schritts, wobei der Laserschweiß-Schritt Richten eines Laserstrahls durch die wenigstens eine zweite Öffnung (110) umfasst.

2. Verfahren nach Anspruch 1, wobei in dem Schritt zum Ausrichten des Schaltungsträgers (100) eine optische Bewertung der Position des ersten elektronischen Bauteils (102) durchgeführt wird, indem Bilder des elektronischen Bauteils (102) durch die erste Öffnung (114) hindurch aufgenommen und bewertet werden.

3. Verfahren nach Anspruch 1 oder 2, wobei das erste elektronische Bauteil (102) ein optoelektronisches Bauteil ist, das zum Senden und/oder Empfangen von Strahlung betrieben werden kann.

4. Verfahren nach einem der vorangehenden Ansprüche, wobei in dem Schritt des Befestigens des Schaltungsträgers (100) an der Gehäusekomponente (106) ein Heißpräge-Schritt durchgeführt wird.

5. Verfahren nach einem der Ansprüche 1 bis 4, wobei die erste Öffnung (114) in der Gehäusekomponente (106) eine optisch funktionale Apertur zum Formen eines einfallenden und/oder emittierten Strahlenbündels bei Betrieb der optoelektronischen Komponente ist.

6. Verfahren nach einem der vorangehenden Ansprüche, wobei das erste elektronische Bauelement (102) mittels einer Chip-on-Board-Technik auf dem Schaltungsträger (100) montiert wird.

7. Verfahren nach einem der vorangehenden Ansprüche, wobei der Schaltungsträger (100) eine Metallkern-Leiterplatte umfasst.

8. Verfahren nach einem der vorangehenden Ansprüche, das des Weiteren den Schritt des Bereitstellens wenigstens eines Abstandshalteelementes (108) an dem Schaltungsträger (100) zum Schaffen eines vorgegebenen Abstandes zwischen der Gehäusekomponente (106) und dem Schaltungsträger (100) in einer Richtung quer zu einer durch den Schaltungsträger definierten Ebene umfasst.

9. Verfahren nach einem der vorangehenden Ansprüche, wobei der Schaltungsträger (100) während des Ausricht-Schrittes mittels elektronisch gesteuerter Aktoren in wenigstens zwei Dimensionen in Bezug auf die Gehäusekomponente (106) bewegt wird.

10. Verfahren nach einem der vorangehenden Ansprüche, das des Weiteren den Schritt zum Ausrichten eines zweiten elektronischen Bauteils (103) beim Montieren desselben auf dem Schaltungsträger (100) unter Verwendung des ersten elektronischen Bauteils (102) als ein Bezugspunkt für seine eigene Position auf dem Schaltungsträger (100) umfasst.

11. Optische Einheit (120) zum Emittieren und/oder Empfangen von Strahlung, wobei die optische Einheit (120) umfasst:
eine Gehäusekomponente (106), die wenigstens eine erste Öffnung (114) aufweist, wobei die Gehäusekomponente zum Formen der Strahlung betrieben werden kann,
einen Schaltungsträger (100), der wenigstens ein optoelektronisches Bauteil (102) aufweist, das zum Senden und/oder Empfangen der Strahlung betrieben werden kann und wenigstens eine zweite Öffnung (110) aufweist,
wobei der Schaltungsträger (100) so ausgerichtet ist, dass das optoelektronische Bauteil (102) in Bezug auf die erste Öffnung (114) in der Gehäusekomponente (106) ausgerichtet ist,
**dadurch gekennzeichnet, dass** wenigstens ein Abstandshalteelement (108) durch Umspritzen des Schaltungsträgers (100) und der wenigstens einen zweiten Öffnung (110) geschaffen wird, um einen vorgegebenen Abstand zwischen dem wenigstens einen optoelektronischen Bauteil (102) und der Gehäusekomponente (106) aufrechtzuerhalten und um einen Laserstrahl (116) durch die wenigstens eine zweite Öffnung (110) zu richten; wobei der Schaltungsträger (100) an der Gehäusekomponente (106) mit einer Laserschweißverbindung (118) befestigt wird, die durch Schmelzen des Materials der Gehäusekomponente (106) und des wenigstens einen Abstandshalteelementes (108) ausgebildet wird.

12. Optische Einheit nach Anspruch 11, wobei der Schaltungsträger (100) eine Metallkern-Leiterplatte umfasst.

13. Optische Einheit nach Anspruch 12, wobei der Metallkern eine Aluminiumlegierung umfasst.

14. Optische Einheit nach einem der Ansprüche 11 bis 13, wobei die Gehäusekomponente (106) eine umspritzte Metallstruktur umfasst.

15. Optische Einheit nach einem der Ansprüche 11 bis 14, wobei die Gehäusekomponente (106) ein Zwei-Komponenten-Teil umfasst, in dem wenigstens eine transparente Linse (126) in ein undurchsichtiges Gehäuse integriert ist.

## Revendications

1. Procédé d'assemblage d'un support de circuit (100) avec un composant de boîtier (106), le procédé comprenant les étapes suivantes :
l'utilisation dudit composant de boîtier (106) comportant au moins une première ouverture (114), et
l'utilisation dudit support de circuit (100) comportant au moins une seconde ouverture (110),
dans lequel il est agencé au moins un premier composant électronique (102) sur ledit support de circuit (100),
l'alignement dudit support de circuit (100) de manière à ce que ledit composant électronique (102) soit aligné par rapport à ladite première ouverture (114) dans le composant de boîtier (106), le premier composant électronique (102) étant directement utilisé comme point de repère pour sa propre position sur le support de circuit (100), et
la fixation du support de circuit (100) au composant de boîtier (106) en effectuant une étape de soudage par laser, l'étape de soudage par laser consistant à diriger le faisceau laser au travers de ladite ou desdites secondes ouverture (110) .

2. Procédé selon la revendication 1, dans lequel, lors de l'étape d'alignement du support de circuit (100), une évaluation optique de la position du premier composant électronique (102) est effectuée par la prise et l'évaluation d'images du composant électronique (102) au travers de la première ouverture (114).

3. Procédé selon la revendication 1 ou la revendication 2, dans lequel ledit premier composant électronique (102) est un composant optoélectronique qui peut être utilisé pour envoyer et/ou recevoir un rayonnement.

4. Procédé selon l'une des revendications précédentes, dans lequel, lors de l'étape de fixation du support de circuit (100) au composant de boîtier (106), une étape d'emboutissage est effectuée.

5. Procédé selon l'une des revendications 1 à 4, dans lequel ladite première ouverture (114) dans le composant de boîtier (106) est une ouverture optiquement fonctionnelle destinée à mettre en forme un rayonnement incident et/ou émis pendant le fonctionnement du composant optoélectronique.

6. Procédé selon l'une des revendications précédentes, dans lequel ledit premier composant électronique (102) est assemblé sur le support de circuit (100) selon une technique de puce sur carte, COB.

7. Procédé selon l'une des revendications précédentes, dans lequel ledit support de circuit (100) comprend une carte à circuit imprimé à âme métallique, MCPCB.

8. Procédé selon l'une des revendications précédentes, comprenant en outre l'étape d'utilisation d'au moins un élément d'écartement (108) au niveau du support de circuit (100) dans le but d'établir une distance prédéfinie entre le composant de boîtier (106) et le support de circuit (100) dans une direction coupant le plan défini par le support de circuit.

9. Procédé selon l'une des revendications précédentes, dans lequel, lors de l'étape d'alignement, ledit support de circuit (100) est déplacé par rapport au composant de boîtier (106) au moyen d'actionneurs commandés électroniquement dans au moins deux dimensions.

10. Procédé selon l'une des revendications précédentes, comprenant en outre l'étape d'alignement d'un second composant électronique (103) lors de son assemblage sur ledit support de circuit (100) en utilisant le premier composant électronique (102) comme point de repère pour sa propre position sur le support de circuit (100).

11. Unité optique (120) destinée à émettre et/ou à recevoir un rayonnement, ladite unité optique (120) comprenant un composant de boîtier (106) comportant au moins une première ouverture (114), le composant de boîtier pouvant être utilisé pour mettre en forme ledit rayonnement,
un support de circuit (100) comportant au moins un composant électronique (102) qui peut être utilisé pour envoyer et/ou recevoir ledit rayonnement, et comportant au moins une seconde ouverture (110),
dans lequel ledit support de circuit (100) et aligné de manière à ce que ledit composant optoélectronique (102) soit aligné par rapport à ladite première ouverture (114) dans le composant de boîtier (106),
**caractérisé en ce qu'**au moins un élément d'écartement (108) est prévu par un surmoulage du support de circuit (100) et de la ou des secondes ouvertures (110) dans le but de maintenir une distance prédéterminée entre le ou les composants optoélectroniques (102) et le composant de boîtier (106) et de diriger un faisceau laser (116) au travers de la ou des secondes ouvertures (110) ; où le support de circuit (100) est fixé au composant de boîtier (106) avec une connexion par soudure laser (118) formée en faisant fondre le matériau du composant de boîtier (106) et du ou des éléments d'écartement (108).

12. Unité optique selon la revendication 11, dans lequel ledit support de circuit (100) comprend une carte à circuit imprimé à âme métallique, MCPCB.

13. Unité optique selon la revendication 12, dans lequel ladite âme métallique comprend un alliage d'aluminium.

14. Unité optique selon l'une des revendications 11 à 13, dans lequel ledit composant de boîtier (106) comprend une structure métallique surmoulée.

15. Unité optique selon l'une des revendications 11 à 14, dans lequel ledit composant de boîtier (106) comprend une pièce à deux composants intégrant au moins une lentille transparente (126) avec une enveloppe opaque.
